# EUROPEAN PATENT APPLICATION

(11) **EP 2 692 795 A1**
(43) Date of publication of application: **05.02.2014**
(21) Application number: 12765870.6
(22) Date of filing: 16.03.2012
(51) Int. Cl.: C08L 63/00, B32B 15/092, C08G 59/42, C08J 5/24, C08K 3/22, C08K 5/092

(54) **RESIN COMPOSITION, PRE-PREG, AND METAL FOIL CLAD LAMINATE**

(30) Priority: 31.03.2011 JP 2011078736
(71) Applicant: Mitsubishi Gas Chemical Company, Inc., Tokyo 100-8324 (JP)
(72) Inventor: TAKADA, Keisuke, Tokyo 125-8601 (JP); KOIZUMI, Kaoru, Tokyo 125-8601 (JP); MORISHITA, Koji, Tokyo 125-8601 (JP)
(74) Representative: HOFFMANN EITLE
(86) International application number: PCT/JP2012/056895
(87) International publication number: WO 2012/132965

(57) **Abstract**

There are provided a resin composition which exhibits high optical reflectance in an ultraviolet light region and a visible light region, undergoes less deterioration in optical reflectance when subjected to a heat treatment and a light irradiation treatment, has an excellent peel strength with a metal foil, and can be used suitably for an LED-mounting printed wiring board; a prepreg using the resin composition; and a metal foil-clad laminate using the resin composition, or the like. A resin composition of the present invention comprises at least an epoxy resin (A) having a bisphenol A skeleton, an alicyclic epoxy resin (B), an acid anhydride (C) of a completely or partially hydrogenated product of an aromatic polycarboxylic acid, titanium dioxide (D), and a dispersing agent (E).

## Description

### Technical Field

The present invention relates to a resin composition, a prepreg, and a metal foil-clad laminate. In particular, the present invention relates to a resin composition, a prepreg, and a metal foil-clad laminate which can be suitably used in a light emitting diode (LED)-mounting printed wiring board.

### Background Art

Conventionally, a laminate or the like obtained by impregnating a glass woven fabric with an epoxy resin containing titanium dioxide and thereafter curing the impregnated glass woven fabric by heating (for example, see Patent Literature 1) has been known as an LED-mounting printed wiring board. However, because this type of laminate using epoxy resin usually has low heat resistance, a substrate surface is discolored by a heat treatment in a producing process and LED-mounting process of a printed wiring board, or by heating or light irradiation when used after LED-mounting, which may cause a problem that reflectance is remarkably decreased.

Because an LED emitting short-wavelength light such as blue light and white light is especially generalized in recent years, a laminate having particularly excellent heat resistance and light resistance has been demanded for the laminate used in the LED-mounting printed wiring board. Therefore, there is required a copper-clad laminate which has excellent heat resistance, exhibits high optical reflectance in an ultraviolet light region and a visible light region, undergoes less deterioration in optical reflectance when subjected to a heat treatment or a light irradiation treatment. A prepreg which is made of a resin composition containing a bisphenol A-based epoxy resin (A), an alicyclic epoxy resin (B), and titanium dioxide (C), and a base material, or the like is proposed for the requirement (for example, see Patent Literature 2).

On the other hand, trial for improving optical reflectance of a substrate for loading an optical semiconductor device is performed by incorporating an alicyclic acid anhydride into a resin composition. A thermosetting optical reflectance resin composition is proposed as the resin composition (for example, see Patent Literature 3). The resin composition contains an epoxy resin (A), a curing agent (B), an inorganic filler (C), a white pigment (D), and a coupling agent (E). The resin composition contains a cyclohexane tricarboxylic acid anhydride as the curing agent (B). The resin composition has optical reflectance of 90% or more in a wavelength of 800 nm to 350 nm after curing, and can be pressure-molded at room temperature (0 to 35°C) before curing.

### Citation List

### Patent Literature

Patent Literature 1: Japanese Patent Laid-Open No. 10-202789
Patent Literature 2: Japanese Patent Laid-Open No. 2008-1880
Patent Literature 3: Japanese Patent Laid-Open No. 2008-106226

### Summary of Invention

### Technical Problem

However, higher brightness and higher output of the LED progress, and the field of application of the LED further extends to large display applications such as television, and home lighting applications from miniaturized display applications such as a previous mobile phone and car navigation. Therefore, a laminate having a further improved performance to discoloration and deterioration caused by heat or light as compared with that of the conventional laminate has been demanded.

The technique of the above-mentioned Patent Literature 2 insufficiently suppresses the deterioration in the optical reflectance when subjected to the heat treatment and the light irradiation treatment, which requires a further improvement. Furthermore, although adhesion (peel strength) with a metal foil is not considered at all, the realization of a resin composition having also an excellent peel strength with the metal foil is requested from the viewpoint of improving the reliability of a metal foil-clad laminate.

On the other hand, in Patent Literature 3, moldability and optical reflectance characteristics in 1.0 mm-thick transfer molding have been under consideration. However, originally, the technique of Patent Literature 3 relates to a tablet molded article having one or more recessed parts (opening parts) as a region for loading an optical semiconductor device, and does not intend the aspect of a prepreg and a metal foil-clad laminate. Therefore, the optical reflectance characteristics of the prepreg or the metal foil-clad laminate, and the peel strength with the metal foil required when used as the metal foil-clad laminate are not specifically considered at all.

In addition, in recent years, a lead-free reflow technique is commonly employed, which provides multilayering and thinning of the prepreg and the laminate. Therefore, higher heat resistance after moisture absorption (solder heat resistance after moisture absorption) than ever before is increasingly required for the resin composition used therefor.

The present invention has been made in view of the above problems. It is an object of the present invention to provide a resin composition which has high optical reflectance, undergoes less deterioration in optical reflectance when subjected to a heat treatment and a light irradiation treatment, has an excellent peel strength with a metal foil, and can be used suitably for an LED-mounting printed wiring board, a prepreg using the resin composition, and a metal foil-clad laminate using the resin composition.

### Solution to Problem

The present inventors have diligently studied in order to solve the problems. As a result, the inventors found that a metal foil-clad laminate which has high optical reflectance, undergoes less deterioration in optical reflectance when subjected to a heat treatment and a light irradiation treatment, and has an excellent peel strength with a metal foil is obtained by using a resin composition containing at least an epoxy resin having a specific kind of bisphenol A skeleton as a thermosetting resin, an alicyclic epoxy resin, an acid anhydride of a completely or partially hydrogenated product of an aromatic polycarboxylic acid, titanium dioxide, and a dispersing agent. Furthermore, the inventors found that a metal foil-clad laminate which has excellent heat resistance after moisture absorption in addition to these characteristics is obtained in a preferable aspect, and the present invention has been attained.

That is, the present invention provides the following items <1> to <15>.
[1] A resin composition comprising at least:
   an epoxy resin (A) having a bisphenol A skeleton;
   an alicyclic epoxy resin (B);
   an acid anhydride (C) of a completely or partially hydrogenated product of an aromatic polycarboxylic acid;
   titanium dioxide (D); and
   a dispersing agent (E).
[2] The resin composition according to [1], wherein the alicyclic epoxy resin (B) is represented by the general formula (1): 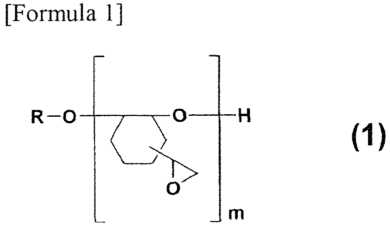 wherein R represents an alkyl group having 1 to 10 carbon atoms or hydrogen atom, and m represents an integer of 1 to 24.
[3] The resin composition according to [1] or [2], wherein the epoxy resin (A) having the bisphenol A skeleton has a skeleton represented by the general formula (2) or a skeleton represented by the general formula (3): 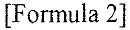 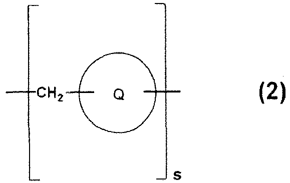 wherein Q is a bisphenol A epoxy monomer residue represented by the following general formula (2a); a methylene group and a single bond which are bonded to Q each are independently bonded to any of two benzene rings of a bisphenol A epoxy monomer; and s represents an integer of 1 or more; 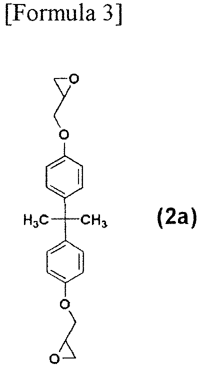 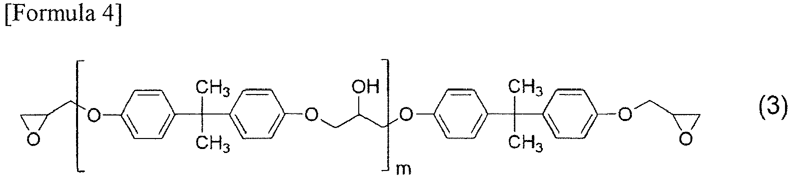 wherein m represents a positive integer.
[4] The resin composition according to any one of [1] to [3], wherein a content of the epoxy resin (A) is 5 to 90 parts by mass based on 100 parts by mass in total of the ingredients (A) to (C).
[5] The resin composition according to any one of [1] to [4], wherein a content of the alicyclic epoxy resin (B) is 5 to 90 parts by mass based on 100 parts by mass in total of the ingredients (A) to (C).
[6] The resin composition according to any one of [1] to [5], wherein a content of the acid anhydride (C) of the completely or partially hydrogenated product of the aromatic polycarboxylic acid is 5 to 40 parts by mass based on 100 parts by mass in total of the ingredients (A) to (C).
[7] The resin composition according to [1] or [6], wherein a content of the titanium dioxide (D) is 10 to 250 parts by mass based on 100 parts by mass in total of the ingredients (A) to (C).
[8] The resin composition according to any one of [1] to [7], further comprising an inorganic filler (F) excluding the titanium dioxide (D),
   wherein a total amount of the titanium dioxide (D) and the inorganic filler (F) is 15 to 450 parts by mass based on 100 parts by mass in total of the ingredients (A) to (C).
[9] The resin composition according to any one of [1] to [8], wherein a mean particle diameter of the titanium dioxide (D) is 5 µm or less.
[10] The resin composition according to any one of [1] to [9], wherein the titanium dioxide (D) is surface-treated by SiO₂, Al₂O₃, ZrO₂, and/or ZnO; and the total amount of 100 parts by mass of the titanium dioxide (D) comprises 1 to 11 parts by mass of SiO₂, 1 to 11 parts by mass of Al₂O₃, 1 to 11 parts by mass of ZrO₂, and/or 1 to 11 parts by mass of ZnO.
[11] The resin composition according to any one of [1] to [10], wherein the dispersing agent (E) is a polymer wet dispersing agent having an acid value of 20 to 200 mgKOH/g.
[12] The resin composition according to any one of [1] to [11], wherein a content of the dispersing agent (E) is 0.05 to 5 parts by mass based on 100 parts by mass in total of the ingredients (A) to (C).
[13] The resin composition according to any one of [1] to [12] for an LED-mounting printed wiring board.
[14] A prepreg obtained by impregnating or coating a base material with a resin composition according to any one of [1] to [13].
[15] A metal foil-clad laminate obtained by placing one prepreg according to [14] or stacking at least two prepregs according to [14], disposing a metal foil on one side or both sides of the prepreg or the stacked prepregs and laminate-molding the metal foil and the prepreg or the stacked prepregs.

### Advantageous Effects of Invention

The resin composition of the present invention has improved heat resistance and optical reflectance and suppresses the deterioration in optical reflectance when subjected to a heat treatment and a light irradiation treatment. Therefore, the prepreg and the metal foil-clad laminate which have excellent heat resistance and optical reflectance, suppress the deterioration in optical reflectance when subjected to the heat treatment and the light irradiation treatment, and have an excellent peel strength with a metal foil can be simply achieved with good reproducibility. In addition, in a preferable aspect of the present invention, the prepreg and the metal foil-clad laminate which further have excellent heat resistance after moisture absorption can be simply achieved with good reproducibility. Therefore, the resin composition, the prepreg, and the metal foil-clad laminate according to the present invention can be used suitably for the LED-mounting printed wiring board or the like, and have extremely high industrial practicality.

### Description of Embodiments

Hereinafter, an embodiment of the present invention will be described. The following embodiment is illustrative in order to describe the present invention. The present invention is not limited only to the embodiment.

A resin composition of the present embodiment is a so-called heat-curable resin composition cured by heat. The resin composition contains at least an epoxy resin (A) having a bisphenol A skeleton, an alicyclic epoxy resin (B), an acid anhydride (C) of a completely or partially hydrogenated product of an aromatic polycarboxylic acid, titanium dioxide (D), and a dispersing agent (E) as indispensable ingredients.

In the epoxy resin (A) having a bisphenol A skeleton used in the present embodiment, an epoxy group is bonded to the bisphenol A skeleton. Epoxy resins known in the art can be suitably selected and used as the epoxy resin (A). The use of the epoxy resin (A) suppresses the discoloration of the obtained prepreg and metal foil-clad laminate when subjected to a heat treatment and a light irradiation treatment, to effectively suppress the deterioration in reflectance.

More specifically, the epoxy resin (A) having the bisphenol A skeleton is preferably an epoxy resin (a novolac-based epoxy resin having a bisphenol A skeleton) having a skeleton represented by the following general formula (2): 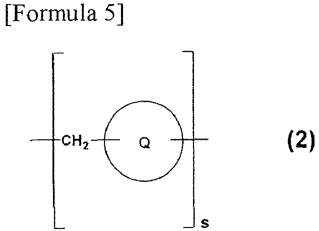 wherein Q is a bisphenol A epoxy monomer residue represented by the following general formula (2a); a methylene group and a single bond which are bonded to Q each are independently bonded to any of two benzene rings of a bisphenol A epoxy monomer; and s represents an integer of 1 or more.

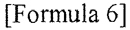

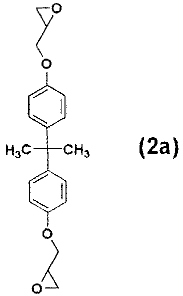

Having the skeleton represented by the general formula (2) means having an independent connected body of repeat units of the following general formula (2c), an independent connected body of repeat units of the following general formula (2d), or a random bonded body or block bonded body of the repeat units of general formulae (2c) and (2d): 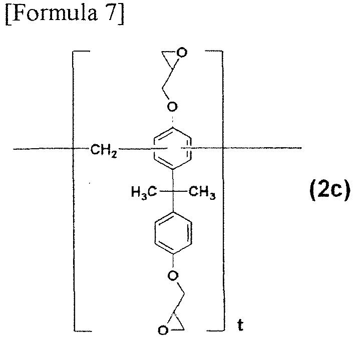 wherein t represents an integer of 1 or more; 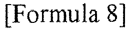 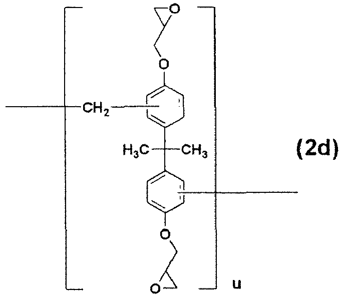 wherein u represents an integer of 1 or more.

An epoxy resin having a skeleton represented by the following general formula (3) can also be preferably used as the epoxy resin (A) having the bisphenol A skeleton: 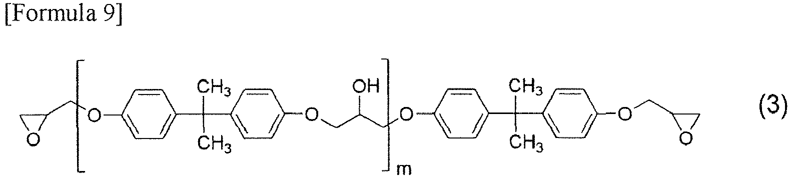 wherein m represents a positive integer.

Herein, the epoxy resin (A) having the bisphenol A skeleton can be easily synthesized by a known technique. For example, the epoxy resin having the skeleton represented by the above general formula (2) is synthesized by reacting bisphenol A skeleton-containing phenol novolac which is an acid condensate of phenol which has a phenolic hydroxyl group and a bisphenol A skeleton and formaldehyde with epichlorohydrin. As the epoxy resin having the skeleton represented by the above general formula (3), for example, a compound having a bisphenol A skeleton (EP-1001 (trade name) (manufactured by Japan Epoxy Resin Co., Ltd.), and N-890 (manufactured by DIC Corporation)) or the like are commercially available. The commercial items can be easily obtained. The epoxy resins (A) having the bisphenol A skeleton may be used singly or in combinations of two or more.

The content of the epoxy resin (A) having the bisphenol A skeleton in the resin composition of the present embodiment is not particularly limited. However, the content of the fluorene-containing epoxy resin (A) is preferably 5 to 90 parts by mass, and more preferably 10 to 80 parts by mass, based on 100 parts by mass in total of the epoxy resin (A) having the bisphenol A skeleton, the alicyclic epoxy resin (B), and the acid anhydride (C) of the completely or partially hydrogenated product of the aromatic polycarboxylic acid. The content of the epoxy resin (A) is set to be within the preferable range, and thereby the discoloration of the obtained prepreg and metal foil-clad laminate when subjected to the heat treatment and the light irradiation treatment tends to be further effectively suppressed to further effectively suppress the deterioration in the reflectance.

Any known epoxy compound having an alicyclic skeleton may be used as the alicyclic epoxy resin (B) used in the present embodiment without particular limitation. The alicyclic epoxy resin (B) is contained with the epoxy resin (A) having the bisphenol A skeleton, the acid anhydride (C) of the completely or partially hydrogenated product of the aromatic polycarboxylic acid, the titanium dioxide (D), and the dispersing agent (E), and thereby the discoloration when subjected to the heat treatment and the light irradiation treatment is suppressed without causing excessive deterioration in the peel strength of the obtained prepreg and metal foil-clad laminate, to effectively suppress the deterioration in the reflectance. Specific examples of the alicyclic epoxy resin (B) include those described in known books and literatures such as "Sousetsu Epoxy Jushi" (published and edited by Epoxy Jushi Gijutsu Kyokai, 1st Edition, issued: November, 2003). Typical examples including specif trade names include 3,4-epoxycyclohexylmethyl-3',4'-epoxycyclohexanecarboxylate (trade name: Celloxide 2021, Celloxide 2021A, and Celloxide 2021P (manufactured by Daicel Chemical Industries, Ltd.), ERL4221, ERL4221D, and ERL4221E (manufactured by The Dow Chemical Company, Japan), SEJ-01R (manufactured by Nippon Kayaku Co., Ltd.)), bis(3,4-epoxycyclohexylmethyl)adipate (trade name: ERL4299 (manufactured by The Dow Chemical Company, Japan), EXA7015 (manufactured by DIC Corporation)), Celloxide 2081 (manufactured by Daicel Chemical Industries, Ltd.), Epikote YX8000 (manufactured by Japan Epoxy Resins Co., Ltd.), Epikote YX8034 (manufactured by Japan Epoxy Resins Co., Ltd.), Epikote YL7170 (manufactured by Japan Epoxy Resins Co., Ltd.), Epolide GT-301, Epolide GT-401, Celloxide 3000 (manufactured by Daicel Chemical Industries, Ltd.)), a 1,2-epoxy-4-(2-oxiranyl)cyclohexane adduct of 2,2-bis(hydroxymethyl)-1-butanol (EHPE3150 (manufactured by Daicel Chemical Industries, Ltd.)) represented by the following general formula (1), 1-epoxyethyl-3,4-epoxycyclohexane, and limonene diepoxide. The alicyclic epoxy resins (B) may be used singly or in combinations of two or more.

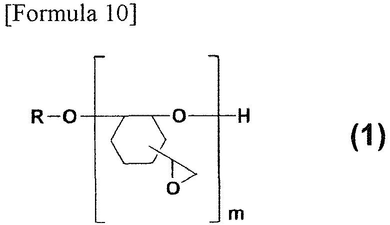

wherein R represents an alkyl group having 1 to 10 carbon atoms or hydrogen atom, and m represents an integer of 1 to 24.

Preferable examples of the alicyclic epoxy resin (B) include 3,4-epoxycyclohexylmethyl-3',4'-epoxycyclohexanecarboxylate, bis(3,4-epoxycyclohexylmethyl)adipate, a 1,2-epoxy-4-(2-oxiranyl)cyclohexane adduct of 2,2-bis(hydroxymethyl)-1-butanol represented by the general formula (1), Epikote YX8000, and Epikote YX8034, which have high heat resistance and effectively suppress discoloration and deterioration when subjected to heat and light. The 1,2-epoxy-4-(2-oxiranyl)cyclohexane adduct of 2,2-bis(hydroxymethyl)-I-butanol represented by the general formula (1) is more preferable.

The content of the alicyclic epoxy resin (B) in the resin composition of the present embodiment is not particularly limited. The content of the alicyclic epoxy resin (E) is preferably 5 to 90 parts by mass based on 100 parts by mass in total of the epoxy resin (A) having the bisphenol A skeleton, the alicyclic epoxy resin (B), and the acid anhydride (C) of the completely or partially hydrogenated product of the aromatic polycarboxylic acid, and more preferably 10 to 80 parts by mass. The content of the alicyclic epoxy resin (B) is set to be within the preferable range, and thereby the discoloration of the obtained prepreg and metal foil-clad laminate when subjected to the heat treatment and the light irradiation treatment tends to be further effectively suppressed to further effectively suppress the deterioration in the reflectance.

Specific examples of the acid anhydride (C) of the completely or partially hydrogenated product of the aromatic polycarboxylic acid used in the present embodiment include, but are not particularly limited to, (1) acid anhydrides such as 1,2,4-cyclohexanetricarboxylic acid-1,2-anhydride and 1,2,4,5-cyclohexanetetracarboxylic acid dianhydride; and (2) acid anhydrides of completely or partially hydrogenated products of 1,2,3-benzenetricarboxylic acid, 1,2,4-naphthalenetricarboxylic acid, 3,3',4,4'-benzophenonetetracarboxylic acid, 2,2',3,3'-benzophenonetetracarboxylic acid, 2,3,3',4'-benzophenonetetracarboxylic acid, 3,3',4,4'-biphenyltetracarboxylic acid, 2,2',3,3'-biphenyltetracarboxylic acid, 2,3,3',4'-biphenyltetracarboxylic acid, 4,4'-oxydiphthalic acid, diphenylmethanetetracarboxylic acid, 1,2,5,6-naphthalenetetracarboxylic acid, 2,3,6,7-naphthalenetetracarboxylic acid, 3,4,9,10-perylenetetracarboxylic acid, anthracenetetracarboxylic acid, 4,4'-(hexafluoroisopropylidene)diphthalic acid, benzenepentacarboxylic acid, and benzenehexacarboxylic acid or the like. The acid anhydrides (C) of the completely or partially hydrogenated products of the aromatic polycarboxylic acids may be used singly or in combinations of two or more.

The acid anhydride (C) of the completely or partially hydrogenated product of the aromatic polycarboxylic acid preferably has alicyclic structures such as monocyclic cycloalkanes, for example, cyclopentane and cyclohexane; monocyclic cycloalkenes, for example, cyclopropene and cyclohexene; bicyclic alkanes, for example, bicycloundecane and decalin; and bicyclic alkenes, for example, norbornene and norbornadiene from the viewpoint of further improving the heat resistance while further suppressing the discoloration when subjected to the heat treatment and the light irradiation treatment, and more preferably has the monocyclic cycloalkanes or the monocyclic cycloalkenes. Preferably, specific examples of the acid anhydride (C) of the completely or partially hydrogenated product of the aromatic polycarboxylic acid include 1,2,4-cyclohexanetricarboxylic acid-1,2-anhydride and 1,2,4,5-cyclohexanetetracarboxylic acid dianhydride.

The content of the acid anhydride (C) of the completely or partially hydrogenated product of the aromatic polycarboxylic acid in the resin composition of the present embodiment is not particularly limited. However, the content of the acid anhydride (C) of the completely or partially hydrogenated product of the aromatic polycarboxylic acid is preferably 5 to 40 parts by mass based on 100 parts by mass in total of the epoxy resin (A) having the bisphenol A skeleton, the alicyclic epoxy resin (B), and the acid anhydride (C) of the completely or partially hydrogenated product of the aromatic polycarboxylic acid, and more preferably 10 to 35 parts by mass. The content of the acid anhydride (C) of the completely or partially hydrogenated product of the aromatic polycarboxylic acid is set to be within the preferable range, and thereby the discoloration when subjected to the heat treatment and the light irradiation treatment tends to be further effectively suppressed without causing excessive deterioration in the peel strength of the obtained prepreg and metal foil-clad laminate, to further effectively suppress the deterioration in the reflectance.

The resin composition of the present embodiment contains the titanium dioxide (D) which is an inorganic filler, as an indispensable ingredient. From the viewpoint of further improving the optical reflectance in the ultraviolet light region and the visible light region, titanium dioxide having a rutile or anatase crystal structure is preferable.

The mean particle diameter (D50) of the titanium dioxide (D) is not particularly limited, and is preferably 5 µm or less, and more preferably 0.5 µm or less. The titanium dioxides (D) may be used singly or in combinations of two or more. For example, titanium dioxides having different particle size distributions and mean particle diameters may be used in a proper combination.

Herein, from the viewpoint of further improving the optical reflectance in the ultraviolet light region and the visible light region, the titanium dioxide (D) is preferably surface-treated by SiO₂, Al₂O₃, ZrO₂, and/or ZnO. In other words, the titanium dioxide (D) preferably has a covering layer containing SiO₂, Al₂O₃, ZrO₂, and/or ZnO. Furthermore, the titanium dioxide (D) is more preferably surface-treated by SiO₂, Al₂O₃, ZrO₂, and/or ZnO, and then subjected to a polyol treatment, a silane coupling agent treatment, and/or an amine treatment. In other words, the titanium dioxide (D) more preferably has a covering layer containing SiO₂, Al₂O₃, ZrO₂, and/or ZnO and being subjected to a polyol treatment, a silane coupling agent treatment, and/or an amine treatment.

When the surface-treated titanium dioxide (D) is used, the total amount of 100 parts by mass of the titanium dioxide (D) preferably contains 1 to 11 parts by mass of SiO₂, 1 to 11 parts by mass of Al₂O₃, 1 to 11 parts by mass of ZrO₂, and/or 1 to 11 parts by mass of ZnO. The amount of the titanium dioxide (D) to be surface-treated is set to be within the preferable range, and thereby the discoloration when subjected to the heat treatment or the light irradiation treatment tends to be further suppressed without causing excessive deterioration in the optical reflectance of the obtained prepreg and metal foil-clad laminate in the ultraviolet light region and the visible light region. The total amount of 100 parts by mass of the titanium dioxide (D) more preferably contains 3 to 11 parts by mass of SiO₂ and 1 to 3 parts by mass of Al₂O₃.

The content of the titanium dioxide (D) in the resin composition of the present embodiment is not particularly limited. The content of the titanium dioxide (D) is preferably 10 to 250 parts by mass, more preferably 25 to 200 parts by mass, based on 100 parts by mass in total of the epoxy resin (A), the alicyclic epoxy resin, and the acid anhydride (C) of the completely or partially hydrogenated product of the aromatic polycarboxylic acid. The content of the titanium dioxide (D) is set to be within the preferable range, and thereby the characteristics of the metal foil-clad laminate tend to be improved and the processability thereof tends to be further facilitated without causing excessive deterioration in the optical reflectance of the obtained prepreg and metal foil-clad laminate in the ultraviolet light region and the visible light region. Specifically, occurrence of breakage or crack caused by conveyance or the like when a printed wiring board and a chip LED are produced tends to be suppressed, and occurrence of a defect of breakage of a drill bit or a dicing blade, or impossibility of processing tends to be suppressed in mechanical drill processing in the printed wiring board and dicing processing in the chip LED.

Any dispersion stabilizer used for coating materials may be suitably used as the dispersing agent (E) used in the present embodiment without particular limitation. Especially, a wet dispersing agent is preferably used. The wet dispersing agent is preferably a polymer wet dispersing agent having an acid group, and more preferably a polymer wet dispersing agent having an acid value of 20 to 200 mgKOH/g. Specific examples thereof include, but are not particularly limited to, polymer wet dispersing agents manufactured by BYK Japan K.K. such as BYK-W161, BYK-W903, BYK-W940, BYK-W996, BYK-W9010, Disper-BYK110, Disper-BYK111, and Disper-BYK180. The dispersing agents (E) may be used singly or in combinations of two or more.

The content of the dispersing agent (E) in the resin composition of the present embodiment is not particularly limited. The content of the dispersing agent (E) is preferably 0.05 to 5 parts by mass, more preferably 0.1 to 4.0 parts by mass, and still more preferably 0.5 to 3.0 parts by mass, based on 100 parts by mass in total of the epoxy resin (A) having the bisphenol A skeleton, the alicyclic epoxy resin (B), and the acid anhydride (C) of the completely or partially hydrogenated product of the aromatic polycarboxylic acid. The content of the dispersing agent (E) is set to be within the preferable range, and thereby heat resistance tends to be further improved, and the dispersibility of the resin with inorganic fillers such as the titanium dioxide (C) in the resin composition tends to be further improved to suppress molding irregularity.

The resin composition of the present embodiment preferably contains an inorganic filler (F) excluding the titanium dioxide (D) (that is, other inorganic filler other than the titanium dioxide (D)) as an ingredient other than the above ingredients. Specific examples of such inorganic filler (F) include, but are not particularly limited to, silicas such as natural silica, synthetic silica, fused silica, amorphous silica, and hollow silica, boehmite, molybdenum compounds such as molybdenum oxide and zinc molybdate, zinc borate, zinc stannate, clay, kaolin, talc, calcined clay, calcined kaolin, calcined talc, mica, zinc oxide, magnesium oxide, zirconium oxide, aluminium hydroxide, alumina, boron nitride, glass short fibers (including fine powders of glasses such as E-glass, T-glass, D-glass, S-glass, and Q-glass), hollow glass, and spherical glass. The inorganic fillers exemplified herein may be used singly or in combinations of two or more. Preferably, the inorganic filler (F) has a mean particle diameter (D50) of 0.2 to 5 µm in light of dispersibility and the like without particular limitation. Among them, from the viewpoint of further improving heat resistance after moisture absorption without causing excessive deterioration in the peel strength of the obtained prepreg and metal foil-clad laminate, boehmite is preferable.

The content of the inorganic filler (F) in the resin composition of the present embodiment is not particularly limited. However, the content of the inorganic filler (F) is preferably 5 to 200 parts by mass based on 100 parts by mass in total of the epoxy resin (A) having the bisphenol A skeleton, the alicyclic epoxy resin (B), and the acid anhydride (C) of the completely or partially hydrogenated product of the aromatic polycarboxylic acid, and more preferably 15 to 150 parts by mass. The content of the inorganic filler (F) is set to be within the preferable range, and thereby the discoloration when subjected to the heat treatment and the light irradiation treatment tends to be further suppressed without causing excessive deterioration in the peel strength of the obtained prepreg and metal foil-clad laminate.

The total of the contents of the titanium dioxide (D) and the inorganic filler (F) in the resin composition of the present embodiment is not particularly limited. However, from the viewpoint of suppressing the discoloration when subjected to the heat treatment and the light irradiation treatment and further improving the processability, the total is preferably 15 to 450 parts by mass based on 100 parts by mass in total of the ingredients (A) to (C).

Furthermore, the resin composition of the present embodiment may contain a epoxy resin (hereinafter "other epoxy resins") other than the ingredients (A) and (B) as ingredients other than those listed above. Examples of the other epoxy resins include, but are not particularly limited to, bisphenol E-based epoxy resins, bisphenol F-based epoxy resins, bisphenol S-based epoxy resins, phenol novolac-based epoxy resins having no bisphenol A skeleton, cresol novolac-based epoxy resins, biphenyl-based epoxy resins, naphthalene-based epoxy resins, trifunctional phenol-based epoxy resins, tetrafunctional phenol-based epoxy resins, glycidyl ester-based epoxy resins, phenolaralkyl-based epoxy resins, biphenylaralkyl-based epoxy resins, naphtholaralkyl-based epoxy resins, dicyclopentadiene-based epoxy resins, or halides thereof. The other epoxy resins may be used singly or in combinations of two or more.

The resin composition of the present embodiment may contain curing accelerators to properly adjust a curing speed if necessary. This type of curing accelerator is known in the art. For example, any curing accelerator commonly used as curing accelerators for epoxy resins or phenolic resins may be suitably used. Specific examples of the curing accelerator include, but are not particularly limited to, organometal salts of copper, zinc, cobalt, and nickel or the like, imidazoles and derivatives thereof, and tertiary amines. The curing accelerators may be used singly or in combinations of two or more.

The resin composition of the present embodiment may contain ingredients other than those listed above in such an amount that does not sacrifice desired properties of the resin composition. Examples of the optional formulation include various polymeric compounds such as heat-curable resins, thermoplastic resins, and oligomers or elastomers thereof, flame-retardant compounds, and various additives or the like other than those listed above. Any of them which are commonly used in the art may be used without particular limitation. Specific examples of the flame-retardant compounds include nitrogen-containing compounds such as melamine and benzoguanamine, and oxazine ring-containing compounds. Specific examples of the additives include ultraviolet absorbers, antioxidants, photopolymerization initiators, fluorescent brighteners, photosensitizers, dyes, pigments, thickeners, lubricants, antifoaming agents, dispersants, leveling agents, brighteners, polymerization inhibitors, silicone powders, and silane coupling agents. For example, when the resin composition of the present embodiment contains a silicone powder, the discoloration of the obtained prepreg and metal foil-clad laminate when subjected to light irradiation tends to be suppressed to further improve the reflectance after the light irradiation. These optional formulations may be used singly or in combinations of two or more.

Furthermore, the resin composition of the present embodiment may contain solvents if necessary. For example, when the organic solvents are used, the viscosity of the resin composition when the resin composition is prepared can be lowered, to improve the handleability of the resin composition and the impregnatability of a glass cloth with the resin composition. Any organic solvent may be used without particular limitation as long as the mixture of the ingredients (A) to (C) can be dissolved therein or is compatible therewith. Specific examples thereof include, but are not particularly limited to, ketones such as acetone, methyl ethyl ketone, methyl isobutyl ketone, and cyclohexanone, aromatic hydrocarbons such as benzene, toluene, and xylene, amides such as dimethylformamide and dimethylacetamide, and propylene glycol methyl ether and acetate thereof. The solvents may be used singly or in combinations of two or more.

The resin composition of the present embodiment can be prepared by an ordinary method. As long as the method is a preparing method providing a resin composition uniformly containing the epoxy resin (A) having the bisphenol A skeleton, the alicyclic epoxy resin (B), the acid anhydride (C) of the completely or partially hydrogenated product of the aromatic polycarboxylic acid, the titanium dioxide (D), the dispersing agent (E), the inorganic filler (F) excluding the titanium dioxide (D) to be incorporated if necessary, and the other optional ingredients, the preparing method is not particularly limited. For example, the epoxy resin having the bisphenol A skeleton, 1,2,4-cyclohexanetricarboxylic acid-1,2-anhydride, the titanium dioxide, the polymer wet dispersing agent having an acid group, and the other inorganic filler are sequentially incorporated into the solvent, and the mixture is sufficiently stirred. Thereby, the resin composition of the present embodiment can be easily prepared.

An organic solvent can be used if necessary when the resin composition is prepared. Any organic solvent may be used without particular limitation as long as the mixture of the epoxy resin (A) having the bisphenol A skeleton, the alicyclic epoxy resin (B), and the acid anhydride (C) of the completely or partially hydrogenated product of the aromatic polycarboxylic acid can be dissolved therein or is compatible therewith. The specific examples are previously described.

Known treatments (stirring, mixing, and kneading treatments or the like) can be performed to uniformly dissolve or disperse ingredients when the resin composition is prepared. For example, a method for stirring and dispersing the titanium dioxide (D) in the resin composition performs stirring-dispersion treatment using a stirring vessel to which a stirrer having suitable stirring capability is attached, to improve the dispersibility of the titanium dioxide (D) for the resin composition. The stirring, mixing, and kneading treatments can be properly performed by using apparatuses aiming at mixing such as a ball mill and a bead mill, or known apparatuses such as revolution and rotation type mixing apparatuses.

On the other hand, a prepreg of the present embodiment can be obtained by combining the resin composition with a base material, specifically by impregnating or coating the base material with the resin composition. A method for producing the prepreg may be performed in accordance with an ordinary method without particular limitation. For example, the prepreg of the present embodiment can be produced by impregnating or coating the base material with the resin composition containing the epoxy resin having the bisphenol A skeleton, 1,2,4-cyclohexanetricarboxylic acid-1,2-anhydride, the titanium dioxide, the polymer wet dispersing agent having an acid group, and the inorganic filler, and thereafter heating the impregnated or coated base material in a drier of 100 to 200°C for 1 to 30 min to semi-cure (B-stage) the resin composition. The amount of the resin composition (including the titanium dioxide (C) and the inorganic filler (F)) is preferably in the range of 30 to 90% by mass based on the total amount of the prepreg of the present embodiment.

The base material used when the prepreg is produced is not particularly limited. Known base materials used in various materials for printed wiring boards may be properly selected and used depending upon contemplated applications and properties. Specific examples thereof include glass fibers such as E-glass, D-glass, S-glass, Q-glass, spherical glass, NE-glass, and T glass fibers, inorganic fibers other than the glass fibers such as quartz fibers, and organic fibers such as polyimide, polyamide, and polyester fibers. These base materials may be properly selected and used depending upon contemplated applications and properties. The base materials may be used singly or in combinations of two or more. A woven cloth, a nonwoven cloth, a roving, a chopped strand mat, and a surfacing mat or the like are known as the shape of the base material. Plain weave, basket weave, and twill weave or the like are known as a method for weaving the woven cloth. These known products may be properly selected and used depending upon contemplated applications and properties. Products subjected to open treatment and a glass woven fabric surface-treated by using a silane coupling agent or the like are suitably used. The thickness or mass of the base material is not particularly limited. Usually, the base material having a thickness of about 0.01 to 0.3 mm is suitably used. Especially, from the viewpoint of a strength and a water-absorbing property, the base material is preferably a glass woven fabric having a thickness of 200 µm or less and a mass of 250 g/m² or less, and more preferably a glass woven fabric made of a glass fiber of E-glass.

On the other hand, the metal foil-clad laminate of the present embodiment can be obtained by placing one prepreg or stacking at least two prepregs, disposing a metal foil on one side or both sides of the prepreg or the stacked prepregs, and laminate-molding the metal foil and the prepreg or the stacked prepregs. Specifically, the metal foil-clad laminate of the present embodiment can be produced by placing one prepreg or stacking a plurality of prepregs, disposing a metal foil made of copper or aluminum or the like on one side or both sides of the prepreg or the stacked prepregs if desired, and laminate-molding the metal foil and the prepreg or the stacked prepregs if necessary. Any metal foil used for the materials for printed wiring boards may be used herein without particular limitation, and known copper foils such as a rolling copper foil and an electrolysis copper foil are preferable. The thickness of the metal foil is not particularly limited. The thickness is preferably 2 to 70 µm, and more preferably 2 to 35 µm. A method and condition for molding the metal foil-clad laminate are not particularly limited. Techniques and conditions for conventional laminates for printed wiring boards and multilayered boards can be applied. For example, when the metal foil-clad laminate is molded, a multistage pressing machine, a multistage vacuum pressing machine, a continuous molding machine, and an autoclave molding machine or the like can be used. The lamination molding is generally carried out in the ranges of a temperature of 100 to 300°C, a planar pressure of 2 to 100 kgf/cm², and a heating time of 0.05 to 5 hr. Furthermore, postcuring may also be performed at a temperature of 150 to 300°C if necessary. A multilayered board can be formed by lamination molding of a combination of the prepreg of the present embodiment with a separately provided wiring board for an internal layer.

The metal foil-clad laminate of the present embodiment may be suitably used as the printed wiring board by forming a predetermined wiring pattern. The metal foil-clad laminate of the present embodiment has excellent heat resistance, exhibits high optical reflectance in the ultraviolet light region and the visible light region, undergoes less deterioration in optical reflectance when subjected to the heat treatment and the light irradiation treatment, has an excellent peel strength with the metal foil, and further has excellent heat resistance after moisture absorption in a preferable aspect. Therefore, the metal foil-clad laminate of the present embodiment may be used especially effectively for the printed wired board requiring the properties, particularly the LED-mounting printed wiring board.

### Examples

Hereinafter, the present invention will be described in detail with reference to preparation examples, examples, and comparative examples. However, the present invention is not limited to these examples in any way. Hereinafter, unless otherwise noted, "part" represents "part by mass".

### (Preparation Example 1)

Into a five-necked 300 ml glass round bottom flask equipped with semicircular stainless-steel agitating blades, a nitrogen duct, a Dean-Stark with cooling tube, a thermometer, and a glass end cap, 100 g of 1,2,4-cyclohexanetricarboxylic acid-1,2-anhydride (H-TMAn manufactured by Mitsubishi Gas Chemical Co., Inc.) and 100 g of methyl ethyl ketone were added all together. The flask was then heated on a mantle heater to raise a temperature within a reaction system to 80°C over about 10 min. The mixture was stirred for 60 min to form a uniform solution. The solution was air-cooled to 50°C in about 10 min to obtain a solution having a solid content concentration of 50% by mass.

### (Example 1)

24 parts by mass of the solution obtained in preparation example 1 (12 parts by mass of 1,2,4-cyclohexanetricarboxylic acid-1,2-anhydride (H-TMAn)), 27 parts by mass of an epoxy resin having a bisphenol A skeleton represented by the following formula (3) (EP-1001 manufactured by Japan Epoxy Resin Co., Ltd.) as an epoxy resin having a bisphenol A skeleton, 61 parts by mass of an 1,2-epoxy-4-(2-oxiranyl)cyclohexane adduct of 2,2-bis(hydroxymethyl)-1-butanol (EHPE-3150 manufactured by Daicel Chemical Industries, Ltd.) as an alicyclic epoxy resin, 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), and 1.75 parts by mass of a dispersing agent (BYK-W903 manufactured by BYK Japan K.K.) were stirred and mixed in a homomixer, to obtain a varnish.

The varnish was diluted with methyl ethyl ketone in equal amounts with respect to the mass. A 0.08 mm-thick E glass cloth was impregnated with the diluted varnish. The E glass cloth was heated at 160°C for 4 min, to obtain a prepreg having a resin composition content of 48% by mass.

Next, the two prepregs were stacked, and 12 µm-thick electrolysis copper foils were disposed on both upper and lower sides of the stack. The copper foils and the stack were pressure-molded by using a vacuum pressing machine under conditions of a temperature of 220°C, a planar pressure of 30 kg/cm², a vacuum of 30 mmHg or less, and a time of 150 min, to obtain a 0.2 mm-thick double-sided copper-clad laminate.

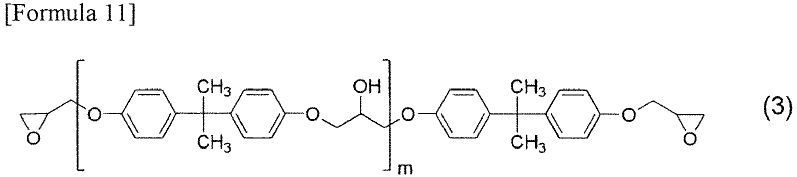

wherein m represents a positive integer.

### (Example 2)

28 parts by mass of the solution obtained in preparation example 1 (14 parts by mass of 1,2,4-cyclohexanetricarboxylic acid-1,2-anhydride (H-TMAn)), 12 parts by mass of an epoxy resin having a bisphenol A skeleton represented by the following formula (4) (N-890 manufactured by DIC corporation) as a novolac-based epoxy resin having a bisphenol A skeleton, 74 parts by mass of an alicyclic epoxy resin (EHPE-3150), 75 parts by mass of titanium dioxide (CR90), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

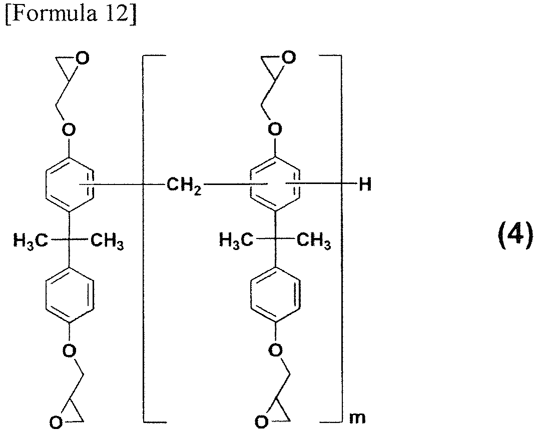

wherein m represents a positive integer.

A portion containing m repeat units in a skeleton represented by the general formula (4) means an independent connected body of repeat units of general formula (2c), an independent connected body of repeat units of general formula (2d), or a random bonded body or block bonded body of the repeat units of general formulae (2c) and (2d) as in the skeleton represented by the general formula (2).

### (Example 3)

28 parts by mass of the solution obtained in preparation example 1 (14 parts by mass of 1,2,4-cyclohexanetricarboxylic acid-1,2-anhydride (H-TMAn)), 25 parts by mass of an epoxy resin having a bisphenol A skeleton (N-890 manufactured by DIC corporation), 62 parts by mass of an alicyclic epoxy resin (EHPE-3150), 75 parts by mass of titanium dioxide (CR90), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

### (Example 4)

26 parts by mass of the solution obtained in preparation example 1 (13 parts by mass of 1,2,4-cyclohexanetricarboxylic acid-1,2-anhydride (H-TMAn)), 75 parts by mass of an epoxy resin having a bisphenol A skeleton (N-890), 12 parts by mass of an alicyclic epoxy resin (EHPE-3150), 75 parts by mass of titanium dioxide (CR90), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

### (Example 5)

28 parts by mass of the solution obtained in preparation example 1 (14 parts by mass of 1,2,4-cyclohexanetricarboxylic acid-1,2-anhydride (H-TMAn)), 25 parts by mass of an epoxy resin having a bisphenol A skeleton (N-890), 61 parts by mass of an alicyclic epoxy resin (EHPE-3150), 75 parts by mass of titanium dioxide (CR90), 1.75 parts by mass of a dispersing agent (BYK-W903), and 5 parts by mass of a silicone powder (KMP605 manufactured by Shin-Etsu Chemical Co., Ltd.) were stirred and mixed in a homomixer, to obtain a varnish.

A prepreg and a 0.2 mm-thick double-sided copper-clad laminate were obtained in the same manner as in example 1 except for using the varnish.

### (Example 6)

28 parts by mass of the solution obtained in preparation example 1 (14 parts by mass of 1,2,4-cyclohexanetricarboxylic acid-1,2-anhydride (H-TMAn)), 25 parts by mass of an epoxy resin having a bisphenol A skeleton (N-890), 61 parts by mass of an alicyclic epoxy resin (EHPE-3150), 75 parts by mass of titanium dioxide (CR90), 1.75 parts by mass of a dispersing agent (BYK-W903), and 5 parts by mass of a silicone powder (TSP120 manufactured by Momentive Performance Materials Inc.) were stirred and mixed in a homomixer, to obtain a varnish.

A prepreg and a 0.2 mm-thick double-sided copper-clad laminate were obtained in the same manner as in example 1 except for using the varnish

### (Example 7)

28 parts by mass of the solution obtained in preparation example 1 (14 parts by mass of 1,2,4-cyclohexanetricarboxylic acid-1,2-anhydride (H-TMAn)), 25 parts by mass of an epoxy resin having a bisphenol A skeleton (N-890), 61 parts by mass of an alicyclic epoxy resin (EHPE-3150), 75 parts by mass of titanium dioxide (CR90), 1.75 parts by mass of a dispersing agent (BYK-W903), and 50 parts by mass of boehmite (AOH60 manufactured by Nabaltec AG) were stirred and mixed in a homomixer, to obtain a varnish.

A prepreg and a 0.2 mm-thick double-sided copper-clad laminate were obtained in the same manner as in example 1 except for using the varnish.

### (Example 8)

28 parts by mass of the solution obtained in preparation example 1 (14 parts by mass of 1,2,4-cyclohexanetricarboxylic acid-1,2-anhydride (H-TMAn)), 25 parts by mass of an epoxy resin having a bisphenol A skeleton (N-890), 61 parts by mass of an alicyclic epoxy resin (EHPE-3150), 75 parts by mass of titanium dioxide (CR90), 1.75 parts by mass of a dispersing agent (BYK-W903), and 75 parts by mass of boehmite (AOH60) were stirred and mixed in a homomixer, to obtain a varnish.

A prepreg and a 0.2 mm-thick double-sided copper-clad laminate were obtained in the same manner as in example 1 except for using the varnish.

### (Comparative Example 1)

28 parts by mass of the solution obtained in preparation example 1 (14 parts by mass of 1,2,4-cyclohexanetricarboxylic acid-1,2-anhydride (H-TMAn)), 86 parts by mass of an alicyclic epoxy resin (EHPE-3150), 75 parts by mass of titanium dioxide (CR90), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

### (Comparative Example 2)

22 parts by mass of the solution obtained in preparation example 2 (11 parts by mass of 1,2,4-cyclohexanetricarboxylic acid-1,2-anhydride (H-TMAn)), 28 parts by mass of an epoxy resin having a bisphenol F skeleton represented by the following formula (5) (FQ-025 manufactured by DIC corporation), 61 parts by mass of an alicyclic epoxy resin (EHPE-3150), 75 parts by mass of titanium dioxide (CR90), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

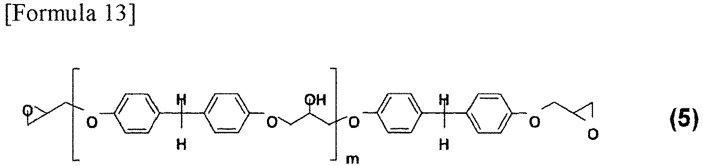

wherein m represents a positive integer.

### (Comparative Example 3)

28 parts by mass of the solution obtained in preparation example 1 (14 parts by mass of 1,2,4-cyclohexanetricarboxylic acid-1,2-anhydride (H-TMAn)), 25 parts by mass of an epoxy resin represented by the following formula (6) (N-770 manufactured by DIC corporation), 61 parts by mass of an alicyclic epoxy resin (EHPE-3150), 75 parts by mass of titanium dioxide (CR90), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

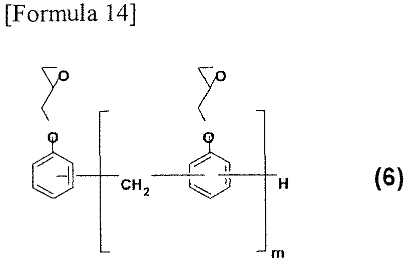

wherein m represents a positive integer.

### (Comparative Example 4)

26 parts by mass of the solution obtained in preparation example 1 (13 parts by mass of 1,2,4-cyclohexanetricarboxylic acid-1,2-anhydride (H-TMAn)), 26 parts by mass of an epoxy resin represented by the following formula (7) (NC3000FH manufactured by DIC corporation), 61 parts by mass of an alicyclic epoxy resin (EHPE-3150), 75 parts by mass of titanium dioxide (CR90), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

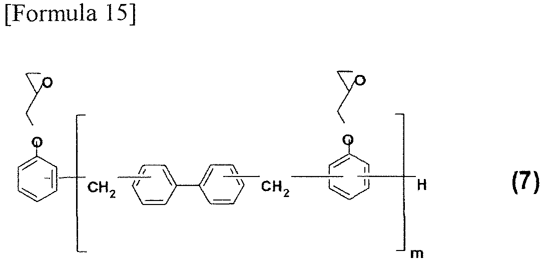

wherein m represents a positive integer.

### (Comparative Example 5)

28 parts by mass of the solution obtained in preparation example 1 (14 parts by mass of 1,2,4-cyclohexanetricarboxylic acid-1,2-anhydride (H-TMAn)), 25 parts by mass of an epoxy resin represented by the following formula (8) (N-680 manufactured by DIC corporation), 61 parts by mass of an alicyclic epoxy resin (EHPE-3150), 75 parts by mass of titanium dioxide (CR90), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

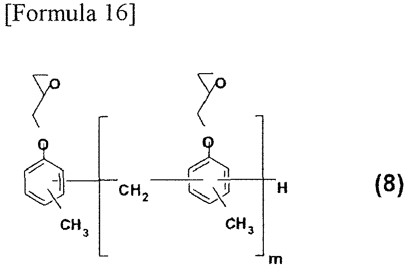

wherein m represents a positive integer.

### (Comparative Example 6)

28 parts by mass of the solution obtained in preparation example 1 (14 parts by mass of 1,2,4-cyclohexanetricarboxylic acid-1,2-anhydride (H-TMAn)), 25 parts by mass of an epoxy resin having a bisphenol A skeleton (N-890), 61 parts by mass of an alicyclic epoxy resin (EHPE-3150), 75 parts by mass of calcined talc (BST200L manufactured by Nippon Talc Co., Ltd.), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

### (Comparative Example 7)

28 parts by mass of the solution obtained in preparation example 1 (14 parts by mass of 1,2,4-cyclohexanetricarboxylic acid-1,2-anhydride (H-TMAn)), 25 parts by mass of an epoxy resin having a bisphenol A skeleton (N-890), 61 parts by mass of an alicyclic epoxy resin (EHPE-3150), 75 parts by mass of boehmite (AOH60), and 1.75 parts by mass of a dispersing agent (BYK-W903) were stirred and mixed in a homomixer, to obtain a varnish.

A prepreg and a 0.2 mm-thick double-sided copper-clad laminate were obtained in the same manner as in example 1 except for using the varnish.

### (Comparative Example 8)

23 parts by mass of hydrogenated methylnadic anhydride (RIKACID HNA-100 manufactured by New Japan Chemical Co., Ltd), 12 parts by mass of an epoxy resin (N890), 65 parts by mass of an alicyclic epoxy resin (EHPE-3150), 75 parts by mass of titanium dioxide (CR90), 1.75 parts by mass of a dispersing agent (BYK-W903), and 0.4 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

The double-sided copper-clad laminates of examples 1 to 8 and comparative examples 1 to 8 obtained as described above were measured and evaluated for reflectance, reflectance after heating, reflectance after light treatment, a peel strength, and solder heat resistance after moisture absorption.

A measuring method and evaluation method of each test method are as follows.

### (Measuring Method)

1) Reflectance: the double-sided copper-clad laminate was cut into a size of 50 x 50 mm with a dicing saw, and the copper foil of the surface was then removed by etching to obtain a measuring sample. The measuring sample was measured for reflectance at 457 nm using a spectrophotometer (CM3610d manufactured by Konica Minolta Holdings, Inc.) based on JIS Z-8722 (average value of n = 5).
2) Reflectance after Heating: the sample obtained in the item 1) was heat-treated in a hot air drier of 215°C for 1 hr, and the sample was then measured for reflectance in the same manner as in the above measurement of the reflectance (average value of n = 5).
3) Reflectance after Light Irradiation: the sample obtained in the above 1) was subjected to light irradiation treatment under condition of 100 mW/cm² of ultraviolet ray (wavelength: 295 to 450 nm) irradiation degree in a weatherometer drier (SUV-F11 manufactured by Iwasaki Electric Co., Ltd.) for 24 hours. The reflectance was then measured in the same manner as in the above measurement of the reflectance (average value of n= 5).
4) Peel Strength: the double-sided copper-clad laminate was cut into a size of 10 x 100 mm with a dicing saw, and the copper foil of the surface was left to obtain a measuring sample. The measuring sample was measured for the tear-off strength of the copper foil using an autograph (AG-IS manufactured by Shimadzu Corporation) (average value of n = 5).
5) Tg: the double-sided copper-clad laminate was cut into a size of 12.7 × 2.5 mm with a dicing saw, and the copper foil of the surface was then removed by etching to obtain a measuring sample. The measuring sample was measured for a glass transition temperature by a DMA method (average value of n = 3).
6) Solder Heat Resistance after Moisture Absorption: the double-sided copper-clad laminate was cut into a size of 50 x 50 mm with a dicing saw, and three-fourths of the copper foil of the surface was removed by etching to obtain a measuring sample. The measuring sample was subjected to moisture absorption in PCT (120°C, 2 atmospheres) for 3 hours, and then immersed in a soldering vessel of 260°C for 1 minute. The change in appearance of the measuring sample was then visually observed (the occurrence number of swellings/the number of tests: n = 3).

Evaluation results are shown in Tables 1 and 2.

**[Table 1]**

| | Example 1 | Example 2 | Example 3 | Example 4 | Example 5 | Example 6 | Example 7 | Example 8 |
|---|---|---|---|---|---|---|---|---|
| Reflectance (%) | 89 | 90 | 90 | 89 | 89 | 90 | 88 | 88 |
| Reflectance after heating (%) | 80 | 79 | 80 | 78 | 79 | 79 | 79 | 78 |
| Reflectance after light irradiation (%) | 85 | 83 | 82 | 56 | 88 | 83 | 82 | 82 |
| Peel strength (kgf/cm) | 0.90 | 0.96 | 0.97 | 0.90 | 0.94 | 0.95 | 1.02 | 0.85 |
| Tg(°C) | 177 | 186 | 193 | 188 | 196 | 198 | 199 | 203 |
| Solder heat resistance after moisture absorption | 2/3 | 3/3 | 2/3 | 1/3 | 2/3 | 3/3 | 0/3 | 0/3 |

**[Table 2]**

| | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|
| Reflectance (%) | 88 | 90 | 89 | 88 | 89 | 35 | 45 | 90 |
| Reflectance after heating (%) | 66 | 68 | 67 | 65 | 69 | 30 | 38 | 65 |
| Reflectance after light irradiation (%) | 84 | 71 | 78 | 74 | 74 | 28 | 18 | 62 |
| Peel strength (kgf/cm) | 0.73 | 0.93 | 0.96 | 0.80 | 0.95 | 0.96 | 0.99 | 0.02 |
| Tg(°C) | 208 | 158 | 190 | 195 | 182 | 186 | 196 | 98 |
| Solder heat resistance after moisture absorption | 0/3 | 3/3 | 3/3 | 3/3 | 3/3 | 3/3 | 3/3 | 3/3 |

From Tables 1 and 2, it was confirmed that all the double-sided copper-clad laminates of examples 1 to 8 have high reflectance, undergo less deterioration in optical reflectance when subjected to a heat treatment and a light irradiation treatment, and have an excellent peel strength. Furthermore, it was confirmed that the double-sided copper-clad laminates of examples 7 and 8 containing the inorganic filler (F) excluding the titanium dioxide (D) have excellent heat resistance after moisture absorption in addition to these characteristics. On the other hand, it was confirmed that the double-sided copper-clad laminates of comparative examples 1 to 5 which do not use an epoxy resin (A) having a bisphenol A skeleton have low reflectance after heating. It was confirmed that the double-sided copper-clad laminates of comparative examples 6 and 7 which do not use the titanium dioxide (D) have low reflectance and undergo a remarkable deterioration in optical reflectance when subjected to a heat treatment and a light irradiation treatment. Furthermore, it was confirmed that comparative example 8 which does not use the acid anhydride (C) of the completely or partially hydrogenated product of the aromatic polycarboxylic acid has low optical reflectance when subjected to a heat treatment and a light irradiation treatment, and undergoes a remarkable deterioration in a peel strength.

As described above, the present invention is not limited to the above-mentioned embodiment and examples, and modifications can be properly made in a scope that does not depart from the gist of the present invention.

### Industrial Applicability

As described above, the present invention can be widely and effectively utilized in various applications such as electrical and electronic materials, a machine tool material, and an aviation material which require heat resistance and light resistance, and peel strength. Particularly, the present invention can be effectively utilized in fields such as a printed wiring board and an LED-mounting printed wiring board which require particularly excellent heat resistance and light resistance, and peel strength.

The present application claims priority from Japanese Patent Application (Japanese Patent Application No. 2011-078736) filed to the Japan Patent Office on March 31, 2011, the contents of which are hereby incorporated by reference.

## Claims

1. A resin composition comprising at least:
an epoxy resin (A) having a bisphenol A skeleton;
an alicyclic epoxy resin (B);
an acid anhydride (C) of a completely or partially hydrogenated product of an aromatic polycarboxylic acid;
titanium dioxide (D); and
a dispersing agent (E).

2. The resin composition according to claim 1, wherein the alicyclic epoxy resin (B) is represented by the general formula (1): 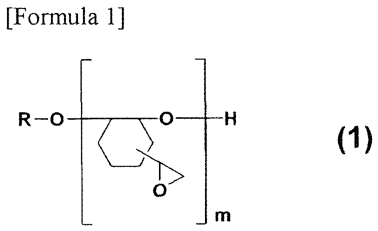 wherein R represents an alkyl group having 1 to 10 carbon atoms or hydrogen atom, and m represents an integer of 1 to 24.

3. The resin composition according to claim 1 or 2, wherein the epoxy resin (A) having the bisphenol A skeleton has a skeleton represented by the general formula (2) or a skeleton represented by the general formula (3): 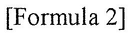 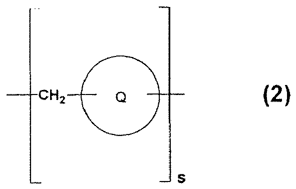 wherein Q is a bisphenol A epoxy monomer residue represented by the following general formula (2a); a methylene group and a single bond which are bonded to Q each are independently bonded to any of two benzene rings of a bisphenol A epoxy monomer; and s represents an integer of 1 or more; 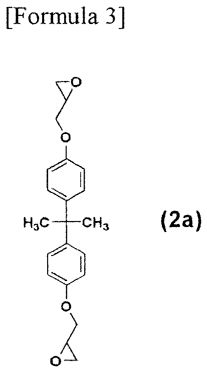 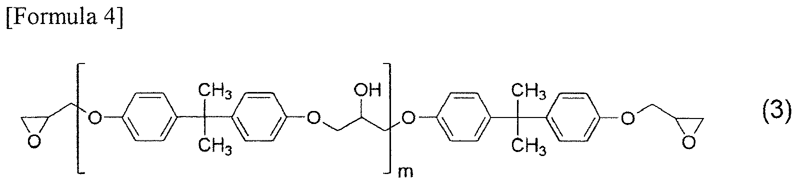 wherein m represents a positive integer.

4. The resin composition according to any one of claims 1 to 3, wherein a content of the epoxy resin (A) is 5 to 90 parts by mass based on 100 parts by mass in total of the ingredients (A) to (C).

5. The resin composition according to any one of claims 1 to 4, wherein a content of the alicyclic epoxy resin (B) is 5 to 90 parts by mass based on 100 parts by mass in total of the ingredients (A) to (C).

6. The resin composition according to any one of claims 1 to 5, wherein a content of the acid anhydride (C) of the completely or partially hydrogenated product of the aromatic polycarboxylic acid is 5 to 40 parts by mass based on 100 parts by mass in total of the ingredients (A) to (C).

7. The resin composition according to any one of claims 1 to 6, wherein a content of the titanium dioxide (D) is 10 to 250 parts by mass based on 100 parts by mass in total of the ingredients (A) to (C).

8. The resin composition according to any one of claims 1 to 7, further comprising an inorganic filler (F) excluding the titanium dioxide (D),
wherein a total amount of the titanium dioxide (D) and the inorganic filler (F) is 15 to 450 parts by mass based on 100 parts by mass in total of the ingredients (A) to (C).

9. The resin composition according to any one of claims 1 to 8, wherein a mean particle diameter of the titanium dioxide (D) is 5 µm or less.

10. The resin composition according to any one of claims 1 to 9, wherein the titanium dioxide (D) is surface-treated by SiO₂, Al₂O₃, ZrO₂, and/or ZnO; and the total amount of 100 parts by mass of the titanium oxide (D) comprises 1 to 11 parts by mass of SiO₂, 1 to 11 parts by mass of Al₂O₃, 1 to 11 parts by mass of ZrO₂, and/or 1 to 11 parts by mass of ZnO.

11. The resin composition according to any one of claims 1 to 10, wherein the dispersing agent (E) is a polymer wet dispersing agent having an acid value of 20 to 200 mgKOH/g.

12. The resin composition according to any one of claims 1 to 11, wherein a content of the dispersing agent (E) is 0.05 to 5 parts by mass based on 100 parts by mass in total of the ingredients (A) to (C).

13. The resin composition according to any one of claims 1 to 12 for an LED-mounting printed wiring board.

14. A prepreg obtained by impregnating or coating a base material with a resin composition according to any one of claims 1 to 13.

15. A metal foil-clad laminate obtained by placing one prepreg according to claim 14 or stacking at least two prepregs according to claim 14, disposing a metal foil on one side or both sides of the prepreg or the stacked prepregs and laminate-molding the metal foil and the prepreg or the stacked prepregs.
